# EUROPEAN PATENT APPLICATION

(11) **EP 3 750 688 A1**
(43) Date of publication of application: **16.12.2020**
(21) Application number: 19750964.9
(22) Date of filing: 29.01.2019
(51) Int. Cl.: B29C 64/135, B29C 64/268, B33Y 10/00, B33Y 30/00, G02F 1/361, H01S 3/00, H01S 3/10, G02B 26/10

(54) **STEREOLITHOGRAPHY DEVICE, AND MANUFACTURING METHOD FOR FORMED OBJECT**

(30) Priority: 06.02.2018 JP 2018018938
(71) Applicant: Osaka University, Suita-shi, Osaka 565-0871 (JP)
(72) Inventor: FUJITA Katsumasa, Suita-shi, Osaka 565-0871 (JP); TAGUCHI Atsushi, Suita-shi, Osaka 565-0871 (JP)
(74) Representative: Banse & Steglich Patentanwälte PartmbB
(86) International application number: PCT/JP2019/002861
(87) International publication number: WO 2019/155933

(57) **Abstract**

Provided are a stereolithography apparatus and a method for producing a shaped article which are applicable to various shaping materials. The stereolithography apparatus according to the present embodiment comprises: laser light source (11) configured to generate laser light (L1) having a wavelength (510 n)m or shorter; objective lens (17) configured to focus the laser light (L1) to shaping material (21); and scanner (13) configured to change a focus position of the laser light (L1) to the shaping material (21), wherein the shaping material (21) is cured by two-photon absorption of the laser light (L1) having a wavelength (510 n)m or shorter to form shaped article (22).

## Description

### Technical Field

The present invention relates to a stereolithography apparatus and a method for producing a shaped article.

### Background Art

Patent Literature 1 discloses a method for producing a three-dimensional microstructure using a photocurable resin. In this method, an uncured resin is irradiated with femtosecond pulsed laser light to cure the photocurable resin. A galvanometer scanner scans a focus position of exposure beam, while a piezo-driven stage scans the focus position in the optical axis direction. This enables shaping of a three-dimensional structure.

The method of Patent Literature 1 exploits a two-photon absorption phenomenon which occurs only at a focal point of laser light. Specifically, the photocurable resin is irradiated with near-infrared laser light having a wavelength of 780 nm. A liquid resin having no absorption at the wavelength of 780 nm and having absorption at a wavelength of 390 nm is used as the photocurable resin. Thus, stereolithography using the two-photon absorption phenomenon is achieved.

Non Patent Literature 1 also discloses a shaping apparatus using two-photon absorption. In Non Patent Literature 1, a Yb:KGW femtosecond laser light source having a wavelength of 1030 nm is used, and a photocurable resin containing a polymerization initiator is irradiated with a second harmonic having a wavelength of 515 nm.

### Citation List

### Patent Literature

Patent Literature 1: Japanese Unexamined Patent Application Publication No. 2003-1599

### Non Patent Literature

Non Patent Literature 1: Malinanuskas, et al. "Femtosecond Visible Light Induced Two-Photon Photopolymerization for 3d Micro/Nanostructuring in Photoresists and photopolymers," Lithuanian Journal of Physics 50, 201 (2010)

### Summary of Invention

### Technical Problem

In Patent Literature 1, a two-photon absorption wavelength is 390 nm because laser light having a wavelength of 780 nm is used. On the other hand, since the absorption of a monomer occurs in the ultraviolet region, two-photon absorption of the monomer cannot be caused directly. Hence, a method of adding a polymerization initiator and a photosensitizer to a photocurable resin is used for directly absorbing visible light for radical formation. In Non Patent Literature 1, a resin material containing a polymerization initiator is similarly used as a shaping material. In this case, the type of a polymerizable monomer is limited. Thus, the technique is difficult to apply to requirements of a wide range of applications.

The present invention has been made in light of these points. An object of the present invention is to provide a stereolithography apparatus and a method for producing a shaped article which are applicable to various shaping materials.

### Solution to Problem

The stereolithography apparatus according to the present embodiment comprises: a laser light source configured to generate laser light having a wavelength of 510 nm or shorter; a lens configured to focus the laser light to a shaping material; and scanning means configured to change a focus position of the laser light to the shaping material, wherein the shaping material is cured by two-photon absorption of the laser light having a wavelength of 510 nm or shorter to form a shaped article.

In the stereolithography apparatus described above, the laser light to irradiate the shaping material preferably has a wavelength of 350 nm or longer.

In the stereolithography apparatus described above, the shaping material preferably comprises a material absorbing ultraviolet light.

In the stereolithography apparatus described above, the shaping material is preferably a material having no absorption at the wavelength of the laser light and having two-photon absorption with a laser wavelength.

In the stereolithography apparatus described above, the shaping material preferably comprises no polymerization initiator.

In the stereolithography apparatus described above, the shaping material is preferably constituted by only a monomer, or only a monomer and a cross-linking agent.

In the stereolithography apparatus described above, the shaping material is preferably irradiated in a pressurized state with the laser light.

In the stereolithography apparatus described above, the shaping material may be cured in an aggregated state of the shaping material to the focus position by laser trapping.

The method for producing a shaped article according to the present embodiment comprises the steps of: generating laser light having a wavelength of 510 nm or shorter; focusing the laser light to a shaping material; curing the shaping material by two-photon absorption of the laser light having a wavelength of 510 nm or shorter; and changing a focus position of the laser light to the shaping material to form a shaped article.

In the production method described above, the laser light to irradiate the shaping material preferably has a wavelength of 350 nm or longer.

In the production method described above, the shaping material is preferably a material having no absorption at the wavelength of the laser light and having two-photon absorption with a laser wavelength.

In the production method described above, the shaping material preferably comprises no polymerization initiator.

In the production method described above, the shaping material is preferably irradiated in a pressurized state with the laser light.

In the production method described above, the shaping material may be cured in an aggregated state of the shaping material to the focus position by laser trapping.

The method for producing a shaped article according to the present embodiment comprises the steps of: generating laser light; focusing the laser light to a shaping material comprising no polymerization initiator; curing the shaping material by two-photon absorption of the laser light; and changing a focus position of the laser light to the shaping material to form a shaped article.

### Advantageous Effects of Invention

The present invention can provide a stereolithography apparatus and a method for producing a shaped article which are applicable to various shaping materials.

### Brief Description of the Drawings

[Fig. 1] Fig. 1 is a diagram showing the configuration of an optical system of the stereolithography apparatus according to the present embodiment.
[Fig. 2] Fig. 2 is a table showing functional groups of molecules and absorption characteristics.
[Fig. 3] Fig. 3 is a graph showing absorption spectra of shaping materials.
[Fig. 4] Fig. 4 is a photograph showing a stereolithographically shaped article obtained using MMA as a shaping material.
[Fig. 5] Fig. 5 is a photograph showing a shaped article in the case of using an aqueous pyrrole solution as a shaping material.
[Fig. 6] Fig. 6 is a photograph showing a shaped article in the case of using pyrrole as a shaping material.
[Fig. 7] Fig. 7 is a diagram showing an electron microscopic image of a shaped article of Example 2.
[Fig. 8] Fig. 8 is an enlarged view of Fig. 7.
[Fig. 9] Fig. 9 is a diagram showing Raman scattering spectra before and after curing.
[Fig. 10] Fig. 10 is a diagram showing an optical microscopic image of a shaped article of Example 3.
[Fig. 11] Fig. 11 is a diagram showing an optical microscopic image of a shaped article of Comparative Example.
[Fig. 12] Fig. 12 is a diagram showing a shaped article of Example 4.
[Fig. 13] Fig. 13 is a photograph showing the shaped article of Example 4.
[Fig. 14] Fig. 14 is a photograph showing a shaped article of Example 5.
[Fig. 15] Fig. 15 is a diagram showing absorption spectra of bovine serum albumin used as a shaping material in Example 5.

### Description of Embodiments

Hereinafter, embodiments to which the present invention is applicable will be described. The description below is given for illustrating the embodiments of the present invention. The present invention is not limited by the embodiments given below. For clarification of explanation, the description given below is appropriately omitted and simplified. Those skilled in the art should be able to readily change, add, or exchange each factor of the embodiments given below within the scope of the present invention. In the drawings, the same reference signs will be used to designate the same or similar factors, so that the description will be appropriately omitted.

### First embodiment

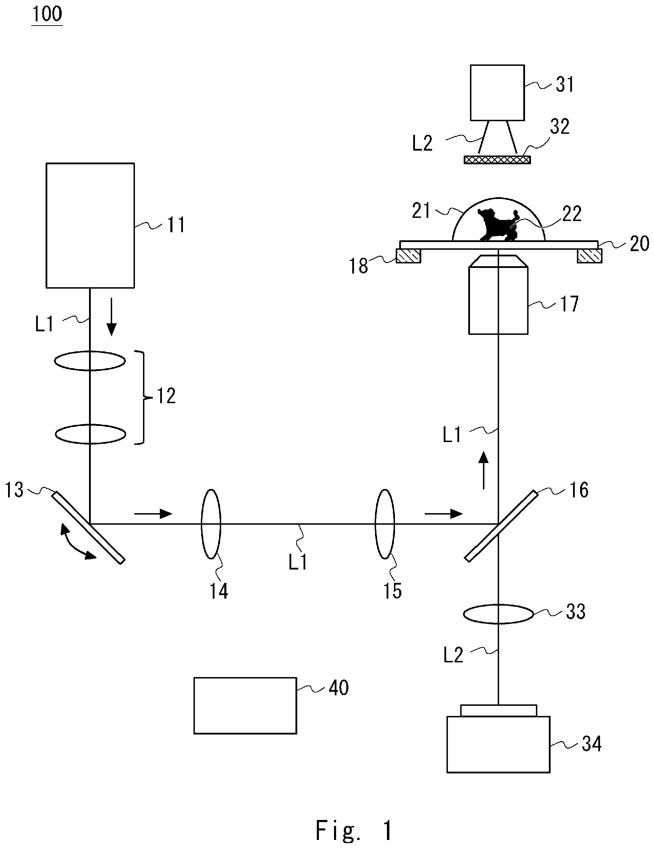

Stereolithography apparatus 100 according to the first embodiment will be described with reference to Fig. 1. Fig. 1 is a diagram showing the configuration of an optical system of stereolithography apparatus 100.

The stereolithography apparatus 100 has laser light source 11, beam expander 12, scanner 13, relay lens 14, relay lens 15, dichroic mirror 16, objective lens 17, driven stage 18, glass substrate 20, illumination light source 31, ultraviolet cut filter 32, imaging lens 33, camera 34, and processing device 40.

First, the optical system for performing stereolithography will be described. The wavelength of the laser light source 11 is preferably 510 nm or shorter. Specifically, laser light L1 is visible light having a wavelength of 400 nm. The laser light source 11 is a pulsed laser light source and generates pulsed laser light. The laser light source 11 may be a tunable laser capable of adjusting a wavelength.

Specifically, the laser light source 11 has a femtosecond titanium-sapphire laser light source and a non-linear optical element. The femtosecond titanium-sapphire laser light source generates pulsed laser light having a wavelength of 800 nm, which serves as a fundamental. The non-linear optical element is BBO (β-BaB₂O₄) crystals or the like and generates a second harmonic. The non-linear optical element generates SHG (second harmonic generation) light having a wavelength of 400 nm. Accordingly, the laser light source 11 outputs SHG light having a wavelength of 400 nm as the laser light L1.

The laser light L1 generated by the laser light source 11 enters the beam expander 12. The beam expander 12 has two lenses and expands the beam diameter of the laser light L1. The laser light from the beam expander 12 enters the scanner 13. The scanner 13 scans the laser light L1 by changing the angle of reflection of a mirror. The scanner 13 is, for example, a biaxial galvanometer mirror and two-dimensionally scans the laser light L1. A light scanner other than the galvanometer mirror may be used, as a matter of course. The scanner 13 changes a relative position of the laser light L1 with respect to the shaping material 21. The scanning by the scanner 13 is controlled by the processing device 40.

The laser light L1 scanned by the scanner 13 enters the dichroic mirror 16 via the relay lenses 14 and 15. The dichroic mirror 16 has a property of reflecting, for example, wavelengths shorter than a wavelength of 510 nm and passing longer wavelengths therethrough. Accordingly, the dichroic mirror 16 reflects the laser light L1 having a wavelength of 400 nm toward the shaping material 21. Since the fundamental having a wavelength of 800 nm included in the laser light L1 passes through the dichroic mirror 16, the shaping material 21 is not irradiated with this fundamental.

The laser light L1 reflected by the dichroic mirror 16 enters the objective lens 17. The objective lens 17 focuses the laser light L1 to irradiate the shaping material 21. This forms a focal point of the laser light L1 in the inside of the shaping material 21. The shaping material 21 is disposed on the glass substrate 20. The shaping material 21 is a resin in a liquid state and is added dropwise onto the glass substrate 20. The shaping material 21 is, for example, a monomer or an oligomer. The glass substrate 20 is a transparent glass cover and is secured on the driven stage 18.

The shaping material 21 is irradiated with the laser light L1 via the glass substrate 20. The glass substrate 20 is placed on the driven stage 18. The driven stage 18 is a piezo-driven stage and moves the shaping material 21 together with the glass substrate 20. The driven stage 18 is, for example, an XYZ three-dimensional driven stage.

The shaping material 21 is cured by two-photon absorption of the laser light L1. The probability of generation of one-photon absorption is usually proportional to laser light intensity, whereas the probability of generation of two-photon absorption is proportional to the square of laser light intensity. The two-photon absorption is an unlikely phenomenon because of its very small absorption cross-section. The two-photon absorption appears remarkably when laser light intensity is very large. Substantially, the two-photon absorption occurs only at the focus position of the laser light L1 focused by the objective lens 17. This can excite a molecule in a spatially small region and can produce high processing accuracy.

The processing device 40 controls the driven stage 18 and the scanner 13. The processing device 40 is, for example, a personal computer having a processor, a memory, a monitor, etc. The processing device 40 controls the scanner 13 such that the shaping material 21 is irradiated with the laser light L1 according to the form to be shaped. As described above, the scanner 13 two-dimensionally scans the laser light L1. The scanner 13 moves the focus position of the laser light L1 within a plane orthogonal to the optical axis of the objective lens 17. This enables two-dimensional shaping. For three-dimensional shaping, the processing device 40 moves the driven stage 18 along the optical axis direction. The driven stage 18 moves the focus position of the laser light L1 along the optical axis direction.

The processing device 40 controls the scanner 13 and the driven stage 18 so as to move the focus position of the laser light L1 within the shaping material 21. The focus position of the laser light L1 is moved according to the form of shaped article 22 to be prepared. The processing device 40 three-dimensionally scans the laser light L1 such that the focus position of the laser light L1 is formed only at a site to be cured. As a result, the shaping material 21 can be cured into the desired form. Therefore, shaped article 22 having a three-dimensional conformation can be produced. In other words, the focal point of the laser light L1 is not formed at a site to be not cured. Furthermore, a shutter that blocks the laser light L1 for irradiation may be established at the site to be not cured.

A scanning path of the laser light L1 appropriate for the form of the shaped article 22 is preset in the processing device 40. The processing device 40 controls the scanner 13 and the driven stage 18 according to the scanning path. An irradiation time at each point can be determined according to laser light intensity and the shaping material 21 such that reaction proceeds sufficiently at each focus position.

The scanning means for the laser light L1 is not limited by the configuration described above. The scanning means is not particularly limited as long as the scanning means can change the focus position of the laser light L1 and the relative position with respect to the shaping material 21. The processing device 40 may move, for example, the objective lens 17, instead of the driven stage 18, along the optical axis direction. Also, the laser light L1 may be scanned using a scanner other than the galvanometer mirror. Alternatively, an XYZ three-dimensional driven stage may be used as the scanning means.

Next, the optical system for observing the shaped article 22 will be described. The optical system for observation has illumination light source 31, ultraviolet cut filter 32, objective lens 17, imaging lens 33, and camera 34. The optical system for observation shown in Fig. 1 is a bright-field optical system, and a dark-field optical system may be used.

The illumination light source 31 is, for example, a lamp light source and generates illumination light L2 as visible light. The illumination light L2 from the illumination light source 31 enters the ultraviolet cut filter 32. The ultraviolet cut filter 32 cuts off ultraviolet ray. The ultraviolet cut filter 32 cuts off ultraviolet ray having a wavelength that cures the shaping material 21 by one-photon absorption. The illumination light L2 that has passed through the ultraviolet cut filter 32 illuminates the shaped article 22 within the shaping material 21.

The illumination light L2 that has passed through the shaping material 21, the shaped article 22, and the glass substrate 20 is refracted by the objective lens 17. The illumination light L2 from the objective lens 17 enters the imaging lens 33 via the dichroic mirror 16. The imaging lens 33 forms an image of the shaped article 22 on a light receiving surface of the camera 34. The camera 34 is a CCD (charged coupled device) camera, a CMOS (complementary metal oxide semiconductor) sensor, or the like and photographs the shaped article 22 in the shaping material 21. The image of the shaped article 22 photographed by the camera 34 is displayed by the processing device 40. As a result, a user can observe the shaping material 21 and the shaped article 22 in real time.

The optical system described above illustrates one example of the stereolithography apparatus 100. The stereolithography apparatus 100 according to the present embodiment is not limited by the configuration shown in Fig. 1.

Next, the shaping material 21 will be described. In the present embodiment, the shaping material 21 is cured by two-photon absorption of the laser light L1. For example, a monomer material is used as the shaping material 21. The shaping material 21 may be a material of a monomer alone, or a mixed material of a monomer and a cross-linking agent.

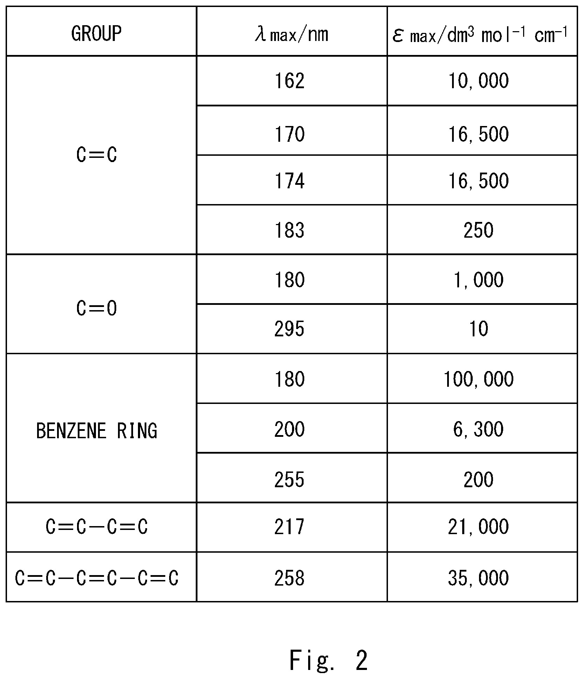

Fig. 2 is a table showing functional groups of molecules and their absorption bands. As shown in Fig. 2, the absorption bands of functional groups of organic molecules have a wavelength, mainly, in a deep ultraviolet region from 180 nm to 260 nm. In this context, the laser light L1 has a wavelength of 350 nm to 510 nm in order to match a two-photon absorption wavelength with the absorption bands of functional groups of molecules. Polymerization reaction can be caused by direct two-photon excitation of a functional group internally present in the monomer or the cross-linking agent. The shaping material 21 is cured through the polymerization reaction. The laser wavelength may be tuned according to a functional group of the resin material contained in the shaping material 21.

The laser light source 11 generates near-infrared femtosecond pulsed laser light as a fundamental and generates its second harmonic generation (SHG) as the laser light L1. Provided that the fundamental has a wavelength of 700 nm to 1020 nm, the laser light L1 generated by the laser light source 11 has a wavelength of 350 nm to 510 nm. The shaping material 21 is irradiated with the laser light L1 having a wavelength of 350 nm to 510 nm. The two-photon absorption wavelength is 175 nm to 255 nm, which is half the laser wavelength. Shaping material 21 having any of the functional groups shown in the table of Fig. 2 is used. The functional group of the monomer contained in the shaping material 21 is excited by two-photon absorption so that a portion thereof is cleaved to cause polymerization reaction with an adjacent monomer.

The polymerization reaction occurs only at a focus position where two-photon absorption takes place. The shaping material 21 is not cured in a region other than the focus position of the laser light. Thus, the shaping material 21 can be cured only at the focus position of the laser light L1. The shaping material 21 is a material having absorption characteristics having absorption at the two-photon absorption wavelength and having no absorption at the laser wavelength. Owing to such characteristics having no absorption at the laser wavelength, the laser light L1 passes through the shaping material 21.

For example, use of the shaping material 21 having no absorption at the laser wavelength can suppress reduction in laser light intensity at the focus position. Specifically, in the case of scanning the focus position in the optical axis direction, the laser light can be prevented from being absorbed by the shaping material 21 short of the focus position.

The shaping material 21 may be a material having absorption for ultraviolet light and having no absorption for visible light. The shaping material 21 comprising such a material absorbing ultraviolet light is cured by two-photon absorption. The shaping material 21 may be a material that passes through visible light. This can suppress reduction in laser light intensity because one-photon absorption no longer occurs. The material may be dissolved in a solvent, such as water, which passes through visible light. For example, an aqueous solution of a resin material absorbing ultraviolet light can be used as the shaping material 21.

The stereolithography can be performed with a monomer alone by using a two-photon absorption wavelength as an absorption band of a functional group of the monomer. For example, an aqueous solution of the monomer may be used as the shaping material 21. Even though the shaping material 21 comprises no polymerization initiator, the shaping material 21 can be polymerized. Use of the shaping material 21 comprising no polymerization initiator can improve processing accuracy. By contrast, in the case of using a material comprising a polymerization initiator, polymerization reaction proceeds by radical polymerization. Polymerization reaction with a free radical cannot be controlled, and processing accuracy might be reduced.

A resin material such as ethylene, styrene, acrylic resin, or epoxy resin can be used as the shaping material 21. Carbon dioxide, a metal, or the like may be used as the shaping material 21. A functional material such as a conductive polymer, a nanocarbon material, or a metal nanocluster may be used as the shaping material 21. Three-dimensional structure preparation and nanopatterning can be achieved using various materials.

As shown in Fig. 2, for example, in the presence of a double bond between two carbon atoms or a double bond between a carbon atom and an oxygen atom, one bond of the double bond is cleaved by two-photon absorption and attached to another atom. As a result, the shaping material 21 can be cured.

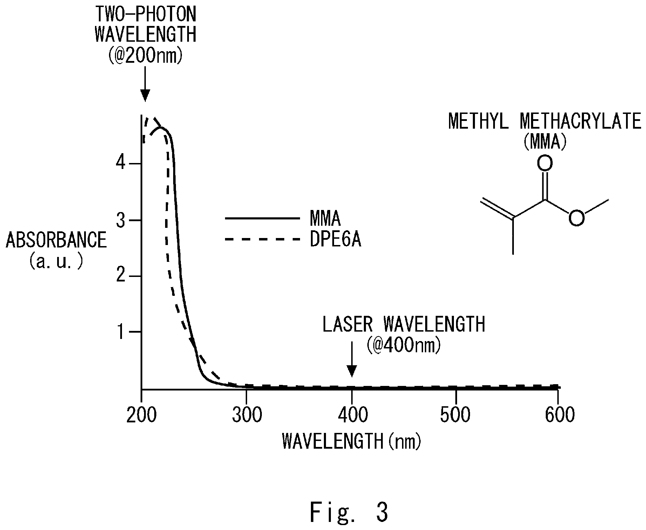

Absorption spectra of the shaping material 21 are shown in Fig. 3. Fig. 3 is a graph showing the absorption spectra of methyl methacrylate (MMA) and DPE6A (dipentaerythritol hexaacrylate). As shown in Fig. 3, these materials have no absorption at the laser wavelength (400 nm) and have absorbance at the two-photon absorption wavelength (200 nm). MMA or DPE6A may be used as the shaping material 21.

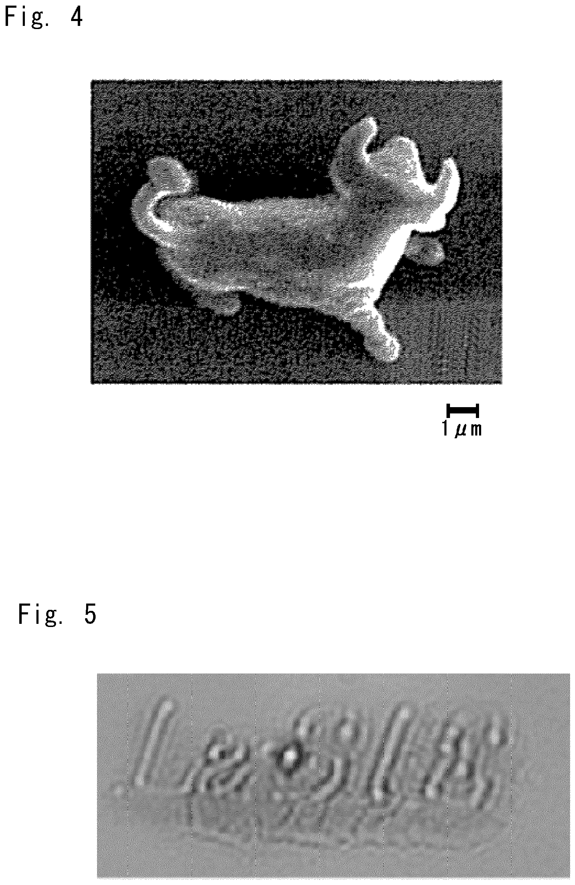

Fig. 4 is a photograph of shaped article 22 prepared using MMA as the shaping material 21. According to the present embodiment, a three-dimensional PMMA (polymethyl methacrylate resin) bovine statue can be shaped.

In the present embodiment, the shaping material 21 is irradiated with laser light having a wavelength of 510 nm or shorter as visible light. The shaping material 21 is cured by two-photon absorption of the shaping material 21 to produce shaped article 22. Since the two-photon absorption wavelength is 255 nm or shorter, the shaping material 21 can be constituted by a monomer alone. Alternatively, the shaping material 21 can be constituted by only a monomer and a cross-linking agent. A material comprising only the monomer or a material comprising only the monomer and the cross-linking agent can be used as the shaping material 21.

A solution of a monomer material as a raw material dissolved in a solvent such as water may be used as the shaping material 21. For example, a solution of only the monomer dissolved or a solution of only the monomer and the cross-linking agent dissolved may be used as the shaping material 21. Various substances such as acrylic resin, ethylene, styrene, or epoxy resin can be used as the shaping material 21. The shaping material 21 is not limited to a liquid and may be a solid or a gas.

Various materials can be used as the shaping material 21 without requiring a polymerization initiator. Preparation of a stereolithographically shaped article and nanopatterning can be achieved using a material such as a conductive polymer, a nanocarbon material, a carbon material (e.g., diamond), a silicon material, or a metal nanocluster. An organic transistor, organic electronics such as organic electro-luminescence, or a nanocircuit can be directly written. Use of shaping material 21 comprising neither a sensitizer nor a polymerization initiator attains high purity and can reduce influence on the physical properties of a final shaped article. Material cost can be reduced without use of the polymerization initiator.

An organic compound other than the monomer, for example, a polymer or an oligomer, may be used as the shaping material 21. Polymers or oligomers may be bonded by two-photon absorption. Two or more different types of materials may be polymerized. A mixture of two or more different types of materials is used as the shaping material 21. Different polymers or an oligomer and a polymer can be bonded by two-photon absorption. Alternatively, a monomer and a polymer may be bonded, or different types of monomers may be bonded. The polymer serving as the shaping material 21 may be a biomaterial such as protein.

A metal atom and an organic compound may be bonded using shaping material 21 comprising fine metal particles or the like. Fine metal particles and a polymer may be mixed and used as the shaping material 21. A mixed liquid of two or more types of materials can be used as the shaping material 21. Also, a material comprising two or more types of metals can be used to prepare an alloy. Preparation of an alloy with a dissimilar metal, or preparation of a hybrid material or a composite material of a metal and a polymer can be achieved. The present invention is applicable to various shaping materials 21. In such a case, two or more laser wavelengths are preferably used according to bonds. For example, laser lights having different wavelengths may be used in irradiation using wavelength-tunable laser. Alternatively, a plurality of laser light sources may be used. In this way, two-photon absorption can be caused at laser wavelengths appropriate for bonds. Therefore, various chemical structures differing in absorption wavelength can be bonded.

The optical system can be constituted by an optical component for visible light by adjusting the laser wavelength to 350 nm or longer. For example, an optical component such as objective lens 17 can be constituted by a component for visible light. Hence, the apparatus can be provided inexpensively as compared with use of optics for ultraviolet ray. When the objective lens 17 is, for example, an optical component for visible light having absorption for ultraviolet light of 350 nm or shorter, the laser wavelength is preferably 350 nm or longer. As a result, the optical system can be constituted with an inexpensive component.

The lower limit value of the laser wavelength may be changed according to the characteristics of the objective lens 17, as a matter of course. For example, for objective lens 17 having absorption from a wavelength of 360 nm wherein the absorption is gradually increased with decrease in wavelength, the laser wavelength is preferably 350 nm or longer, more preferably 360 nm or longer. Furthermore, an optical component for ultraviolet light may be used as the objective lens 17. For example, in the case of using a substance having a shorter absorption wavelength as the shaping material 21, the objective lens 17 is preferably an optical component for ultraviolet light.

Shaping processing and removal processing (cutting) of a material can be achieved in the same apparatus by rendering laser light intensity invariable. In the case of performing removal processing of a material, the laser light intensity is higher than that at the time of shaping processing. In this way, bonds can be cleaved. The shaped article can be cut for removal processing.

Polymerization efficiency can be improved by using the shaping material 21 disposed in a pressurized environment. For example, the shaping material 21 is disposed in a closed container and pressurized. The shaping material 21 is irradiated in this pressurized state with the laser light L1. This elevates the density of the shaping material 21, i.e., the density of the monomer to be polymerized, and therefore facilitates polymerization reaction. The shaping material 21 is disposed as a gas in a pressurized environment to elevate the density of the monomer. Accordingly, the shaping material 21 can be efficiently cured, and the shaping time of the shaped article 22 can be shortened.

The shaped article 22 can be prepared on a nano order or a micron order by focusing the laser light L1 to irradiate the shaping material 21. A stereolithography apparatus and a shaping method which have a convenient prototyping function and are excellent in versatility, precision, and cost can be achieved. The present invention is applicable to the three-dimensional microfabrication field, functional material development, and the nanotechnology field. Since the laser light is focused for irradiation, molecules to be polymerized can be aggregated by laser trapping. The shaping material 21 is irradiated with laser in an aggregated state of the shaping material 21 to the focus position by laser trapping, and thereby cured. Another laser light source may be added in order to perform the laser trapping. The laser light source for laser trapping has a wavelength that is not absorbed by the shaping material 21. Molecules can be aggregated to the focus position by matching the focus position of the laser light source 11 with the focus position of the laser light source for laser trapping. In this way, the stereolithography can be efficiently performed.

In the description above, the wavelength of the laser light L1 is preferably 510 nm or shorter. The wavelength of the laser light L1 can be appropriately changed according to the shaping material 21. The laser wavelength can be twice the absorption wavelength of the shaping material 21. The laser wavelength may be twice the absorption wavelength shown in the table of Fig. 2. The lower limit value of the laser wavelength may depend on limitations to the optical system. When the objective lens 17 is, for example, an objective lens adaptable to wavelengths up to 350 nm, the laser wavelength is preferably 350 nm or longer. In this case, the wavelength of the laser light L1 is preferably 350 nm to 510 nm.

### Example 1

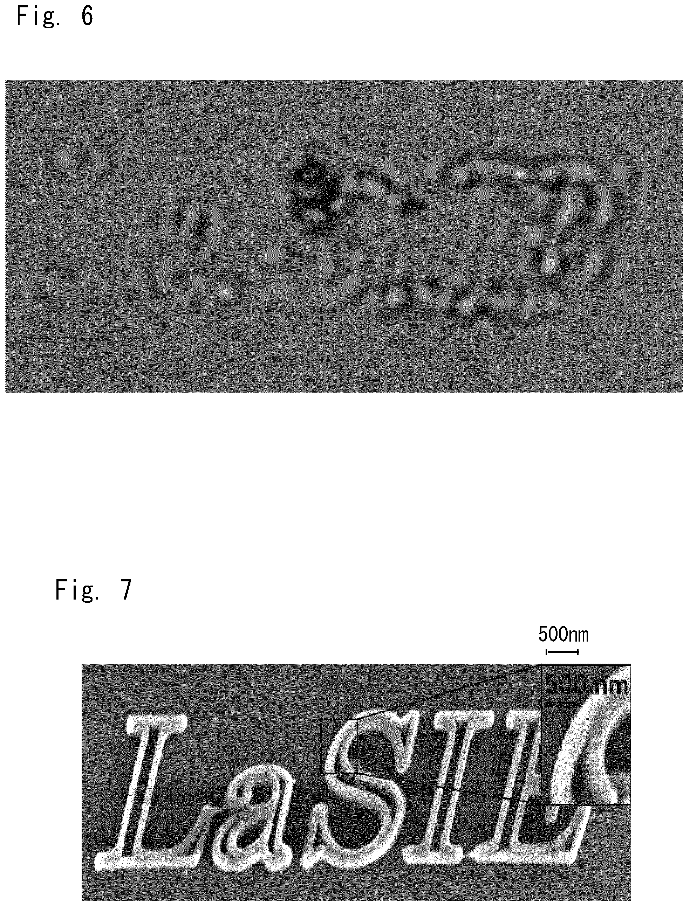

Example about a conductive polymer will be described. In this Example, a monomer pyrrole is used as the shaping material 21. Figs. 5 and 6 are photographs of bright-field images of a structure shaped in Example 1. In Fig. 5, a 0.167 mol/l aqueous pyrrole solution is used as the shaping material 21. In Fig. 6, pyrrole alone is used as the shaping material 21. The laser light L1 is pulsed laser light having a wavelength of 400 nm. The laser light intensity generated by the laser light source 11 is 33 mW. The magnification of the objective lens 17 is 100 times with NA = 1.4.

The monomer pyrrole is polymerized by two-photon absorption of the laser light L1. As a result, shaped article 22 constituted by polypyrrole is prepared. Specifically, shaped article 22 constituted by a conductive polymer can be prepared. The chemical formula of polypyrrole is shown in the following formula (1):

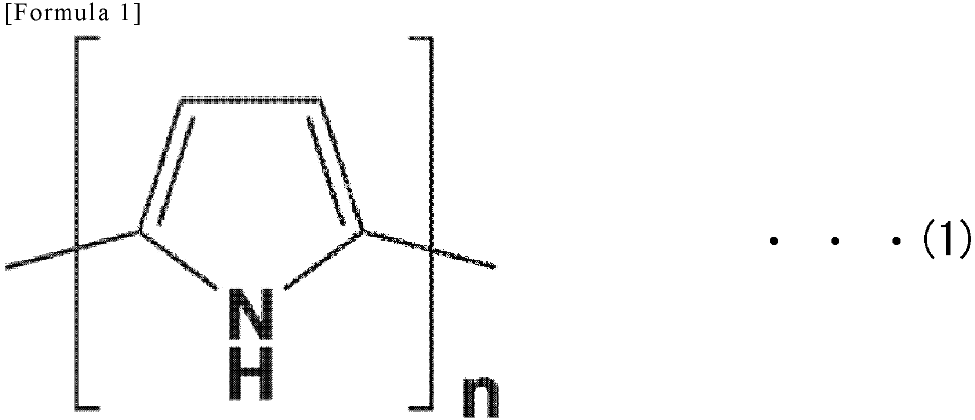

As shown in Figs. 5 and 6, the letters "LaSIE" are two-dimensionally shapable. Such a two-dimensional pattern is also shapable.

The shaped article 22 may be prepared with a conductive polymer other than polypyrrole, as a matter of course. The chemical formulas of polyaniline, polythiophene, polyethylenedioxythiophene (PEDOT), poly(p-phenylene), polyfluorene, poly(p-phenylene vinylene), and polythienylene vinylene as other examples of conductive polymers containing an aromatic group are shown in the following formulas (2) to (8):

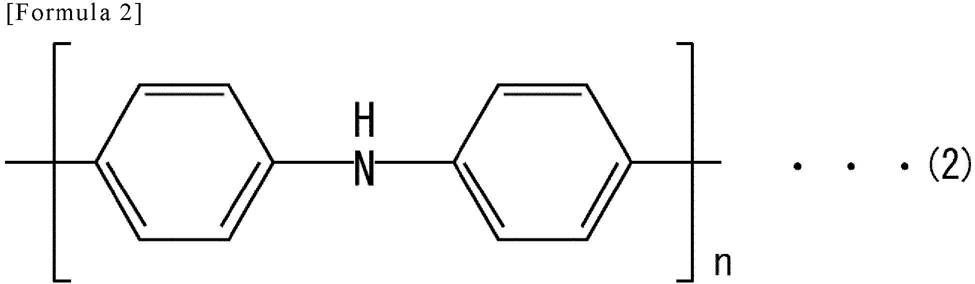

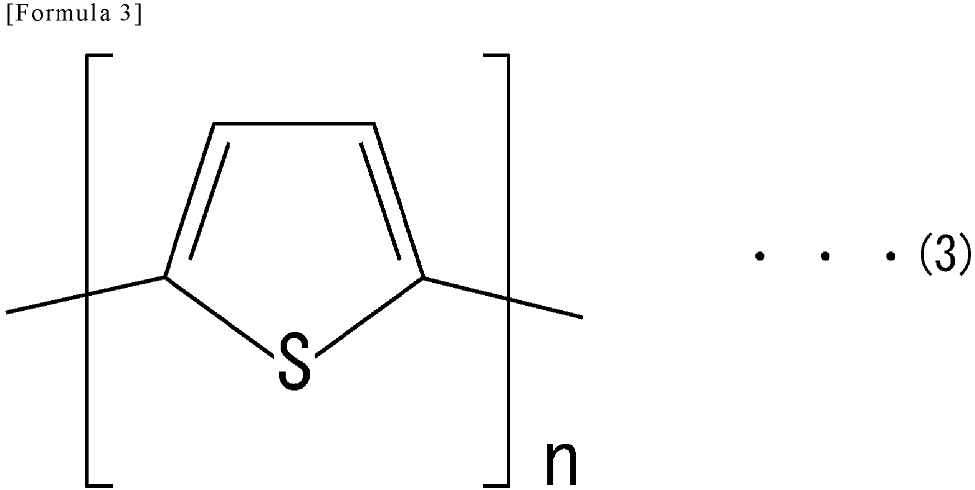

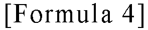

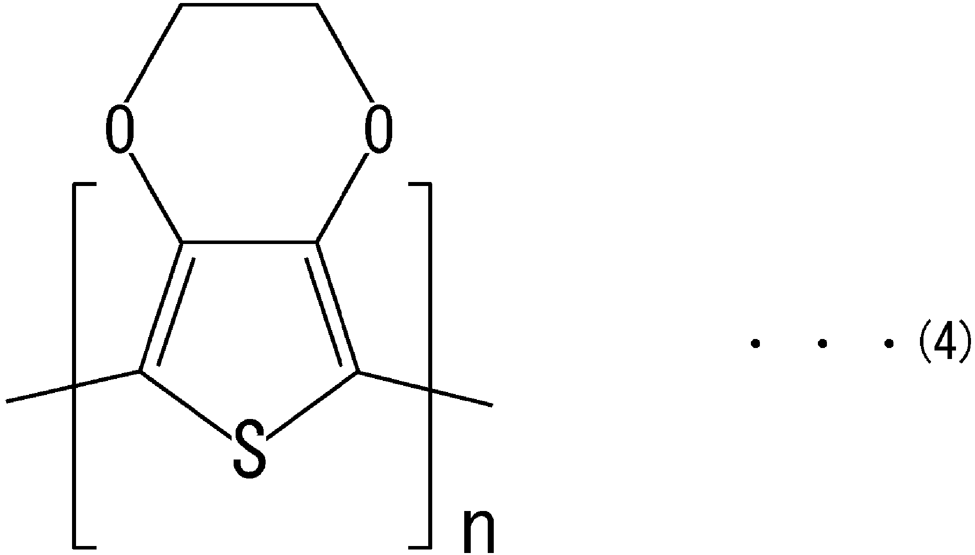

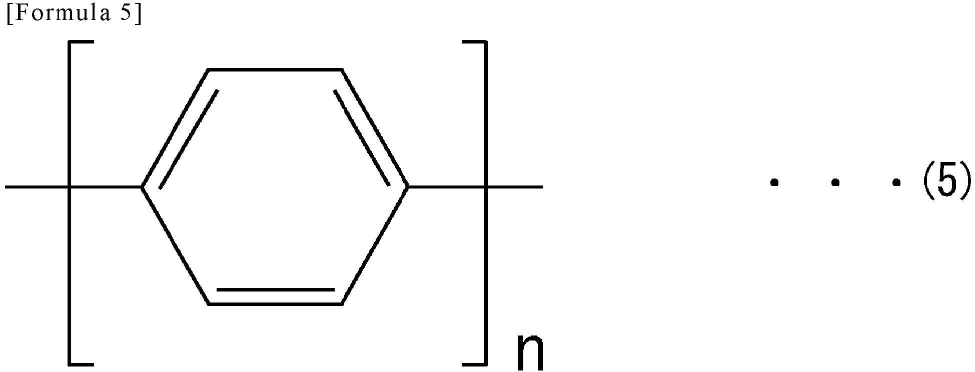

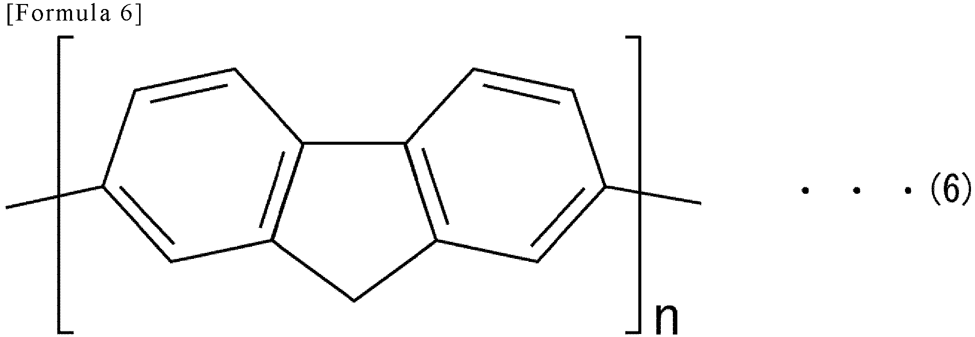

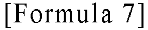

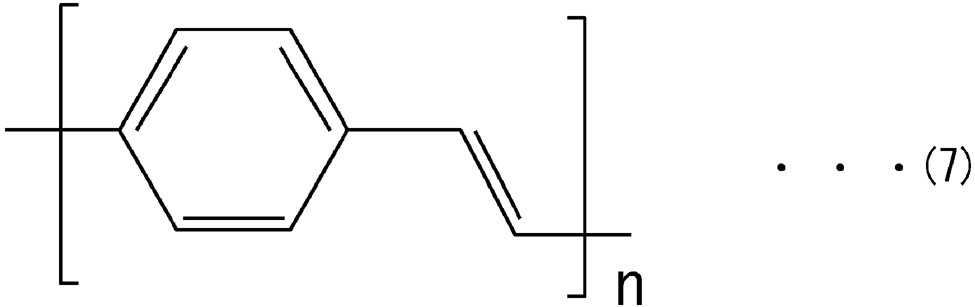

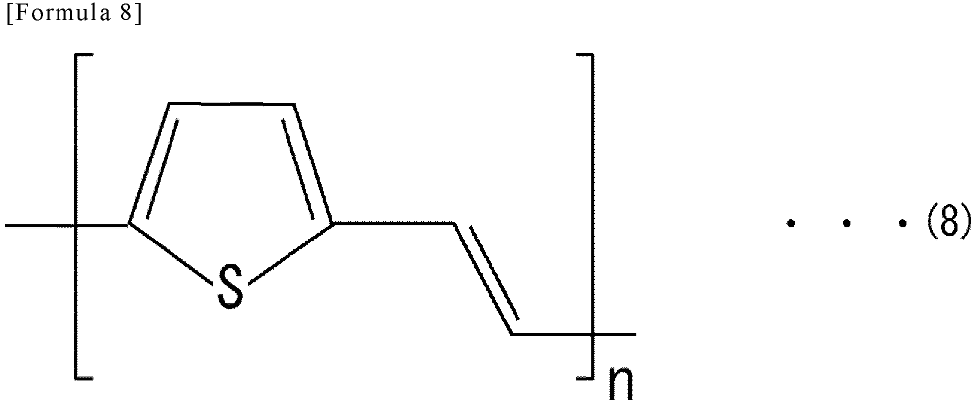

In order to shape the conductive polymers described above, their respective monomers can be used as the shaping material 21. Thus, pyrrole, aniline, thiophene, ethylenedioxythiophene, p-phenylene, fluorene, p-phenylene vinylene, or thienylene vinylene is used as the shaping material 21. A monomer other than the materials described above may be used as the shaping material 21, as a matter of course.

### Example 2

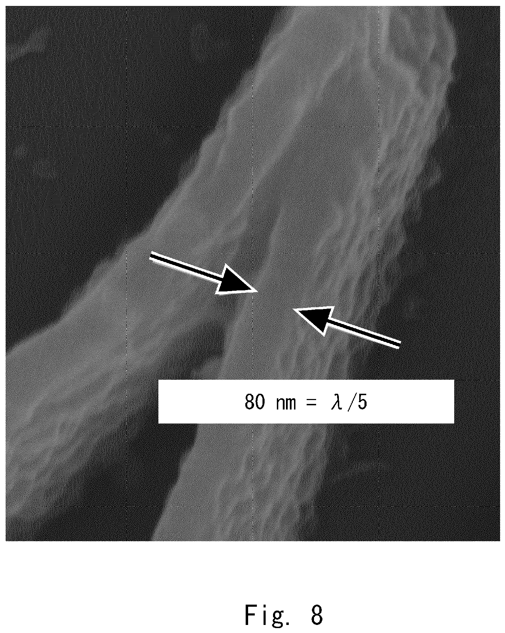

In Example 2, the letters "LaSIE" are shaped using MMA as the shaping material 21. Fig. 7 shows an electron microscopic image of the shaped article in Example 2. The laser light intensity is 5 mW, and the shaping time is 5 minutes. Fig. 8 is a diagram showing an enlarged view of the letter "L" shown in Fig. 7. L & S (line and space) with a line width of 80 nm was able to be prepared at a laser wavelength of 400 nm. MMA is polymerized by two-photon absorption into PMMA. The double bond between C atoms (C=C bond) of MMA is cleaved through polymerization reaction into single bonds in PMMA (see the following chemical formula (9)).

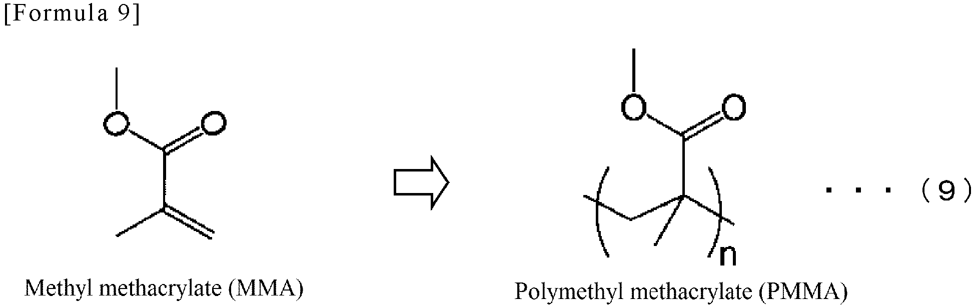

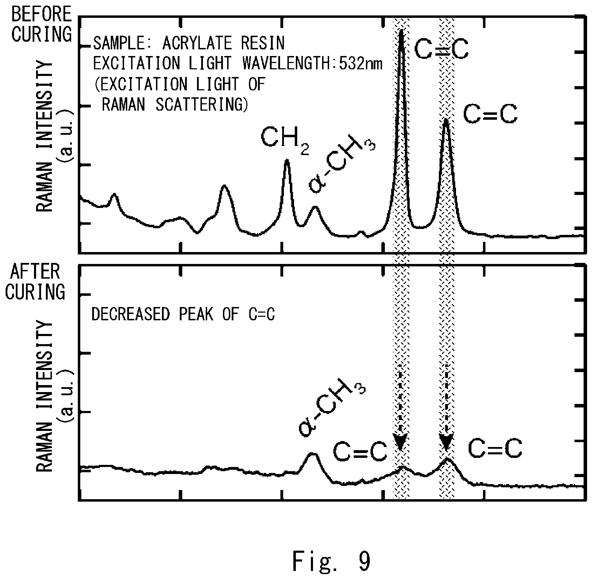

Fig. 9 shows change in Raman scattering spectra caused by polymerization reaction. Specifically, this drawing shows the Raman scattering spectra before curing and the Raman scattering spectra after curing. In Fig. 9, the Raman scattering spectra are normalized with the peak of α-CH₃. Acrylate resin is used as the shaping material, and the excitation light wavelength was 532 nm at the time of Raman spectrum measurement.

The peak of the C=C bond was decreased after curing as compared with before curing. This demonstrates that the C=C bond is cleaved by two-photon absorption to cause polymerization reaction.

### Example 3

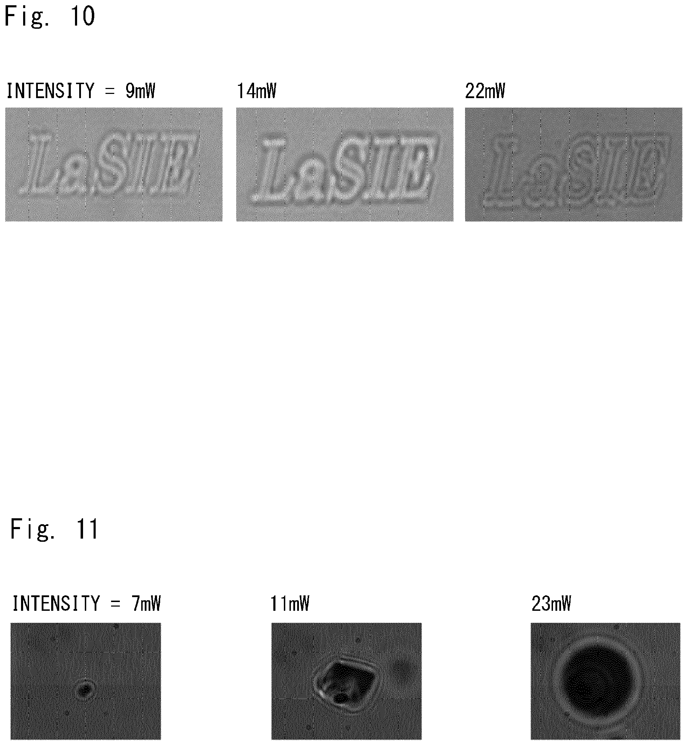

In Example 3, DPE-6E (acrylate oligomer) is used as the shaping material 21. In Example 3, shaping material 21 containing neither a photosensitizer nor a polymerization initiator is used. The laser wavelength is 400 nm, and the laser pulse width is 100 fs. NA of the objective lens is 1.4. Optical microscopic images of shaped articles prepared by shaping with laser intensity of 9 mW, 14 mW, or 22 mW are shown in Fig. 10.

In this Example 3, only the laser wavelength was changed to 530 nm for Comparative Example, which is shown in Fig. 11. Fig. 11 shows optical microscopic images of shaped articles prepared with laser intensity of 7 mW, 11 mW, or 23 mW. In Comparative Example using the laser wavelength of 530 nm, shaping cannot be achieved because air bubbles are generated at a laser irradiation portion so that blackening occurs.

### Example 4

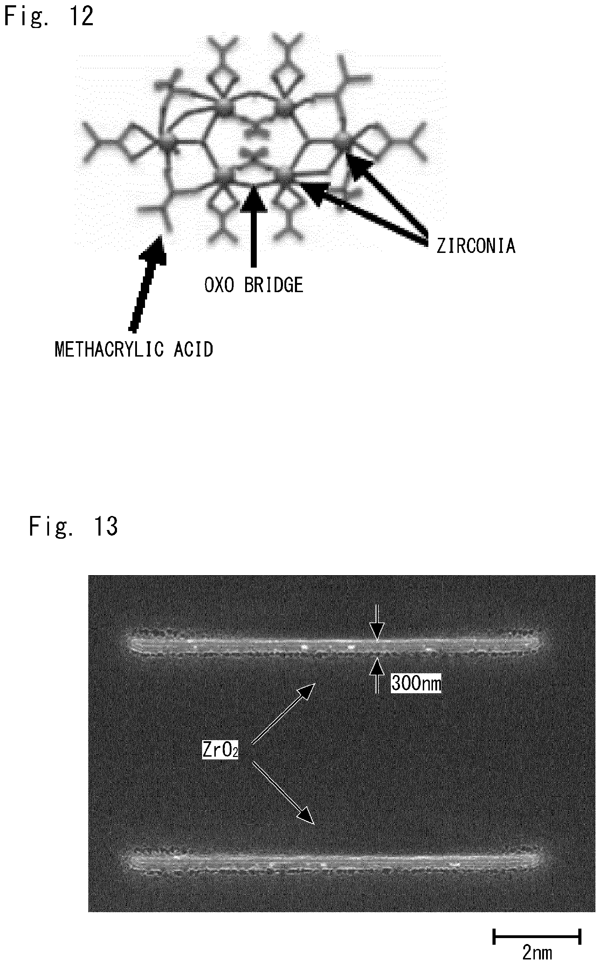

In Example 4, the zirconia oxo cluster shown in Fig. 12 is used as the shaping material 21. Fig. 13 is an electron microscopic image showing the line structure of ZrO₂ prepared using the zirconia oxo cluster as the shaping material 21. The laser wavelength is 400 nm, and the laser intensity is 20 mW. After polymerization, the sample is heated to 600 degrees Celsius to prepare the line structure of ZrO₂. ZrO₂ is a high-k material and as such, can be applied to a gate insulating film for transistors, etc.

### Example 5

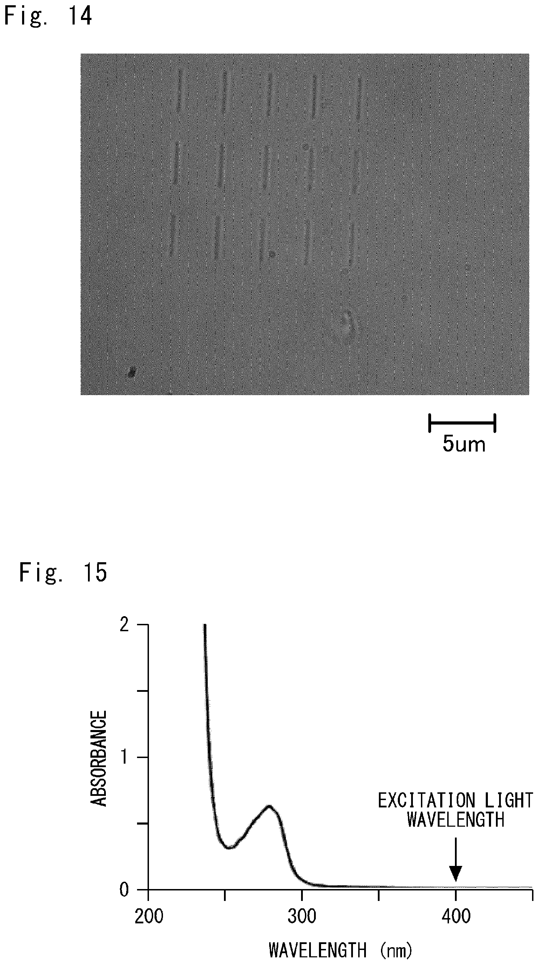

In Example 5, a bioprotein bovine serum albumin (BSA) is used as the shaping material 21. Fig. 14 is an optical microscopic image showing a line structure prepared using BSA as the shaping material 21. Fig. 15 is a graph showing absorption spectra of the bovine serum albumin. The laser wavelength is 400 nm, and the laser intensity is 40 mW. The sample concentration before polymerization is 1.5 mM.

The invention made by the present inventors is specifically described above with reference to the embodiments. However, the present invention is not limited by the embodiments described above. It should be understood that various changes or modifications can be made in the present invention without departing from the spirit of the present invention.

This application claims the priority based on Japanese Patent Application No. 2018-18938 filed on February 6, 2018, the disclosure of which is incorporated herein in their entirety.

### Reference Signs List

- 11: Laser light source
- 12: Beam expander
- 13: Scanner
- 14: Relay lens
- 15: Relay lens
- 16: Dichroic mirror
- 17: Objective lens
- 18: Driven stage
- 20: Glass substrate
- 21: Shaping material
- 22: Shaped article
- 31: Illumination light source
- 32: Ultraviolet cut filter
- 33: Imaging lens
- 34: Camera
- 40: Processing device
- 100: Stereolithography apparatus

## Claims

1. A stereolithography apparatus comprising:
a laser light source configured to generate laser light having a wavelength of 510 nm or shorter;
a lens configured to focus the laser light to a shaping material; and
scanning means configured to change a focus position of the laser light to the shaping material,
wherein the shaping material is cured by two-photon absorption of the laser light having a wavelength of 510 nm or shorter to form a shaped article.

2. The stereolithography apparatus according to Claim 1, wherein the laser light to irradiate the shaping material has a wavelength of 350 nm or longer.

3. The stereolithography apparatus according to Claim 1 or 2, wherein the shaping material comprises a material absorbing ultraviolet light.

4. The stereolithography apparatus according to any one of Claims 1 to 3, wherein the shaping material is a material having no absorption at the wavelength of the laser light and having two-photon absorption with a laser wavelength.

5. The stereolithography apparatus according to any one of Claims 1 to 4, wherein the shaping material comprises no polymerization initiator.

6. The stereolithography apparatus according to any one of Claims 1 to 5, wherein the shaping material is constituted by only a monomer, or only a monomer and a cross-linking agent.

7. The stereolithography apparatus according to any one of Claims 1 to 6, wherein the shaping material is irradiated in a pressurized state with the laser light.

8. The stereolithography apparatus according to any one of Claims 1 to 7, wherein the shaping material is cured in an aggregated state of the shaping material to the focus position by laser trapping.

9. A method for producing a shaped article, comprising the steps of:
generating laser light having a wavelength of 510 nm or shorter;
focusing the laser light to a shaping material;
curing the shaping material by two-photon absorption of the laser light having a wavelength of 510 nm or shorter; and
changing a focus position of the laser light to the shaping material to form a shaped article.

10. The method for producing a shaped article according to Claim 9, wherein the laser light to irradiate the shaping material has a wavelength of 350 nm or longer.

11. The method for producing a shaped article according to Claim 9 or 10, wherein the shaping material is a material having no absorption at the wavelength of the laser light and having two-photon absorption with a laser wavelength.

12. The method for producing a shaped article according to any one of Claims 9 to 11, wherein the shaping material comprises no polymerization initiator.

13. The method for producing a shaped article according to any one of Claims 9 to 12, wherein the shaping material is irradiated in a pressurized state with the laser light.

14. The method for producing a shaped article according to any one of Claims 9 to 13, wherein the shaping material is cured in an aggregated state of the shaping material to the focus position by laser trapping.

15. A method for producing a shaped article, comprising the steps of:
generating laser light;
focusing the laser light to a shaping material comprising no polymerization initiator;
curing the shaping material by two-photon absorption of the laser light; and
changing a focus position of the laser light to the shaping material to form a shaped article.
